# EUROPEAN PATENT APPLICATION

(11) **EP 3 288 018 A1**
(43) Date of publication of application: **28.02.2018**
(21) Application number: 15889630.8
(22) Date of filing: 20.07.2015
(51) Int. Cl.: G09G 3/36, G11C 19/28

(54) **SHIFT REGISTER AND DRIVE METHOD THEREFOR, GATE DRIVE APPARATUS AND DISPLAY PANEL**

(30) Priority: 21.04.2015 CN 201510191089
(71) Applicant: BOE Technology Group Co., Ltd., Beijing 100015 (CN); Beijing BOE Optoelectronics Technology Co., Ltd., Beijing 100176 (CN)
(72) Inventor: WANG, Shijun, Beijing 100176 (CN); CHEN, Xiaochuan, Beijing 100176 (CN); WANG, Lei, Beijing 100176 (CN); ZHANG, Yong, Beijing 100176 (CN)
(74) Representative: Gesthuysen Patent- und Rechtsanwälte
(86) International application number: PCT/CN2015/084472
(87) International publication number: WO 2016/169141

(57) **Abstract**

The present invention provides a shift register and a driving method thereof, a gate driving device and a display panel, such that the shift register can pull down the output terminal by means of DC voltage signals, which reduces the duty cycle of the clock signal and thereby lowers the power consumption of Thin Film Transistors. The shift register comprises a plurality of cascaded shift register elements, each of which comprises: an input module in response to the input signal outputted by an input signal terminal, an output module in response to a voltage signal outputted a the pull-up node, a reset module in response to the reset signal outputted by a reset signal terminal, a first pull-down module in response to the input signal outputted by the input signal terminal and the reset signal outputted by the reset signal terminal, and a second pull-down module in response to a voltage signal of a pull-down node.

## Description

### FIELD OF THE INVENTION

The present invention relates to the field of liquid crystal display (LCD) driving technology, particularly to a shift register and a driving method thereof, a gate driving device and a display panel.

### BACKGROUND ART

Shift registers are used in most panel displays. In recent years, the technology of Gate Driver on Array (GOA) realized by integrating a gate driving device into a liquid crystal panel is widely applied in LCD panels, so as to save materials and reduce production costs. Moreover, as the resolution of mobile phones gets higher and higher, the value of Pixels Per Inch (PPI) of images is on the increase as well, that is, the number of pixels contained in each inch becomes larger. In the prior art, products with 400+ PPI or even 500+ PPI have come out, and a ultra-narrow frame is a mandatory requirement for products with high PPI, so current products are manufactured by the Low Temperature Poly-Silicon (LTPS) technology. Consequently, Amorphous-Silicon (a-Si) products are confronted with severer challenges.

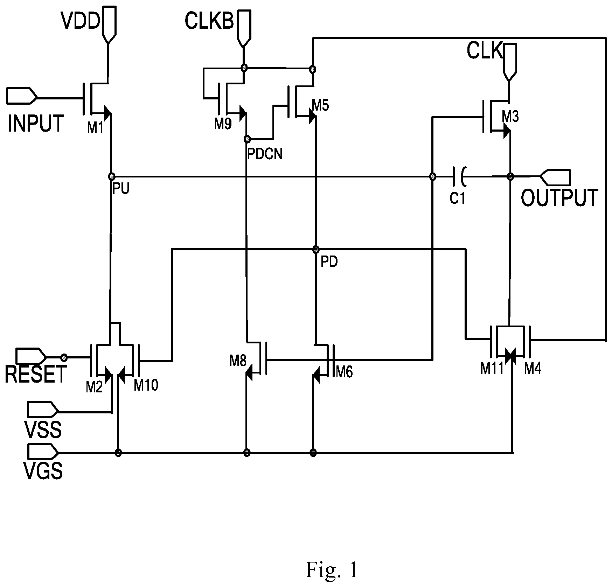

In the prior art, the GOA in a display panel consists of a plurality of shift register elements. Fig.1 shows the structure of a shift register element typically used in the prior art. As shown in Fig.1, the shift register element comprises eleven Thin Film Transistors (TFT). The low level of an output terminal OUTPUT is the one introduced after a fourth TFT M4 and an eleventh TFT M11 are switched on. Since the gate of the fourth TFT M4 is controlled by the high level of a clock signal CLKB and the gate of the eleventh TFT M11 is also controlled by the high level of the clock signal CLKB introduced to a pull-up node, the low level of the output terminal OUTPUT is controlled by the high level signal of the clock signal CLKB. This can be achieved by the clock signal CLKB with a high duty cycle because the output terminal OUTPUT always outputs the low level except at the time in which the high level is outputted.

To sum up, the shift register in the prior art can only pull down the output terminal by the high level of the clock signal, so the clock signal must have a high duty cycle, which increases the power consumption of TFTs.

### SUMMARY OF THE INVENTION

The embodiments of the present invention provide a shift register and a driving method thereof, an array substrate gate driving device and a display panel, so as to enable the shift register to pull down an output terminal by means of DC voltage signals, which reduces the duty cycle of clock signals and thereby lowers the power consumption of TFTs.

The embodiment of the present invention provides a shift register comprising a plurality of cascaded shift register elements, the shift register element comprising:
an input module configured to provide a first DC voltage signal to a pull-up node as the output of the input module in response to an input signal of an input signal terminal;
an output module configured to provide a clock signal to an output terminal of the shift register element in response to a voltage signal outputted by the pull-up node;
a reset module configured to provide a second DC voltage signal to the pull-up node in response to a reset signal, wherein the second DC voltage signal is at a low level when the first DC voltage signal is at a high level, and is at a high level when the first DC voltage signal is at a low level;
a first pull-down module configured to provide the second DC voltage signal or the first DC voltage signal respectively to the pull-down node as the output of the first pull-down module in response to the input signal of the input signal terminal or to the reset signal;
a second pull-down module configured to provide a power supply anode voltage signal to the pull-down node and provide a power supply cathode voltage signal outputted by a power supply cathode to the output terminal in response to a voltage signal of the pull-down node.

According to the shift register of the embodiment of the present invention, when the first DC voltage signal is at a high level and the second DC voltage signal is at a low level, the first pull-down module provides the high level of the first DC voltage signal to the pull-down node in response to the high level outputted by the reset signal terminal, and the second pull-down module provides the low level outputted by the power supply cathode to the output terminal in response to the high level of the pull-down node. When the first DC voltage signal is at a low level and the second DC voltage signal is at a high level, the first pull-down module provides the high level of the second DC voltage signal to the pull-down node in response to the high level outputted by the input signal terminal, and the second pull-down module provides the low level outputted by the power supply cathode to the output terminal in response to the high level of the pull-down node. The shift register can pull down the output terminal by means of the DC voltage signals without relying on a high duty cycle of the clock signal, which reduces the power consumption of TFTs.

Preferably, when the first DC voltage signal is at a high level and the second DC voltage signal is at a low level, the shift register is scanned forwards; and when the first DC voltage signal is at a low level and the second DC voltage signal is at a high level, the shift register is scanned backwards. When the shift register provided by the embodiment of the present invention is scanned both forwards and backwards, the output terminal can be pulled down by means of DC voltage signals.

Preferably, the input module comprises:
a first TFT, a control terminal of the first TFT being connected to the input signal terminal, an input terminal of the first TFT receiving the first DC voltage signal, and an output terminal of the first TFT being connected to the pull-up node.

Preferably, the output module comprises:
a second TFT, a control terminal of the second TFT being connected to the pull-up node, an input terminal of the second TFT receiving a clock signal, and an output terminal of the second TFT being connected to the output terminal; and
a first capacitor connected between the pull-up node and the output terminal.

Preferably, the reset module comprises:
a third TFT, a control terminal of the third TFT receiving the reset signal, an input terminal of the third TFT receiving the second DC voltage signal, and an output terminal of the third TFT being connected to the pull-up node.

Preferably, the first pull-down module comprises:
a fourth TFT, a control terminal of the fourth TFT being connected to the input signal terminal, an input terminal of the fourth TFT receiving the second DC voltage signal, and an output terminal of the fourth TFT being connected to the pull-down node; and
a fifth TFT, a control terminal of the fifth TFT receiving the reset signal, an input terminal of the fifth TFT receiving the first DC voltage signal, and an output terminal of the fifth TFT being connected to the pull-down node.

Preferably, the second pull-down module comprises:
a sixth TFT, a control terminal and an input terminal of the sixth TFT being connected to the power supply anode voltage, and an output terminal of the sixth TFT being connected to the pull-down node; and
a seventh TFT, a control terminal of the seventh TFT being connected to the pull-down node, an input terminal of the seventh TFT being connected to the power supply cathode voltage, and an output terminal of the seventh TFT being connected to the output terminal.

According to the above aspects of the present invention, a shift register element only comprises seven TFTs, so as to achieve the ultra-narrow frame design of the shift register.

The embodiment of the present invention provides a gate driving device comprising any shift register provided by the embodiment of the present invention.

The embodiment of the present invention provides a display panel comprising a gate driving device provided by the embodiment of the present invention.

The embodiment of the present invention provides a method for driving the shift register, the method comprising the steps of:
the input module receiving the input signal of the input signal terminal and providing the first DC voltage signal to a pull-up node as the output of the input module;
the output module receiving the voltage signal outputted by the pull-up node and providing the clock signal to the output terminal of a shift register element;
the reset module receiving the reset signal and providing the second DC voltage signal to the pull-up node, wherein the second DC voltage signal is at a low level when the first DC voltage signal is at a high level, and is at a high level when the first DC voltage signal is at a low level;
the first pull-down module receiving the input signal and the reset signal, and providing the second DC voltage signal or the first DC voltage signal respectively to the pull-down node in response to the input signal or the reset signal; and
after receiving the voltage signal of the pull-down node, the second pull-down module providing the power supply anode voltage signal to the pull-down node and provide the power supply cathode voltage to the output terminal.

In view of the shift register provided by the embodiment of the present invention, when the first DC voltage signal is at a high level and the second DC voltage signal is at a low level, the first pull-down module provides the high level outputted by the first DC voltage signal terminal to the pull-down node in response to the high level outputted by the reset signal terminal, and the second pull-down module provides the low level outputted by the power supply cathode to the output terminal in response to the high level of the pull-down node. When the first DC voltage signal is at a low level and the second DC voltage signal is at a high level, the first pull-down module provides the high level outputted by the second DC voltage signal terminal to the pull-down node in response to the high level outputted by the input signal terminal, and the second pull-down module provides the low level outputted by the power supply cathode to the output terminal in response to the high level of the pull-down node. In doing so, the shift register provided by the present invention pulls down the output terminal by means of DC voltage signals, which reduces the duty cycle of the clock signal, thereby reducing the power consumption of the TFTs.

Preferably, when the shift register is scanned forwards, the first DC voltage signal is at a high level and the second DC voltage signal is at a low level; and when the shift register is scanned backwards, the first DC voltage signal is at a low level and the second DC voltage signal is at a high level.

When the shift register provided by the embodiment of the present invention is scanned both forwards and backwards, the output terminal can be pulled down by means of DC voltage signals.

### BRIEF DESCRIPTION OF DRAWINGS

Fig. 1 is a structural schematic view of a shift register in the prior art;
Fig. 2 is a structural schematic view of a shift register provided by an embodiment of the present invention;
Fig. 3 is a control signal timing diagram of the shift register provided by an embodiment of the present invention;
Fig. 4 is a further control signal timing diagram of the shift register provided by an embodiment of the present invention; and
Fig. 5 is a structural schematic view of a GOA driving device provided by an embodiment of the present invention.

### DETAILED DESCRIPTION OF THE INVENTION

The technical solutions in the embodiments of the present invention will be described clearly and fully with reference to the drawings herein. Apparently, the embodiments described herein are only a part of, rather than entire, embodiments of the present invention. All other embodiments obtained by a person of ordinary skill on the basis of the embodiments herein without making inventive effort fall within the protection scope of the present invention.

Embodiments of the present invention provides a shift register and a driving method thereof, a gate driving device and a display panel, such that the shift register pulls down the output terminal by means of DC voltage signals, which reduces the duty cycle of clock signals and thereby lowers the power consumption of TFTs.

It needs to be explained that the shift register in the embodiments of the present invention relates to an improvement to the a-Si shift register in the prior art. In an embodiment of the present invention, the voltage VSS provided by the cathode of the power supply is a low level, and the voltage VDD provided by the anode of the power supply is a high level. The TFTs in the embodiment of the present invention may all be N-type TFTs, or all be P-type TFTs, or may be a combination of N-type TFTs and P-type TFTs. The N-type TFT is taken as an example in the following depiction. All the N-type TFTs are switched on when the gate voltage is a high level and are switched off when the gate voltage is a low level. A person of ordinary skill shall understand that the implementation of the shift register is not limited to N-type TFTs and can select any type of TFTs according to the design requirements.

Generally speaking, the shift register consists of a plurality of cascaded shift register elements, and each shift register comprises n rows of shift register elements. Each row of the shift register element comprises one shift register element. Scanning signals need to be inputted when the shift register is in normal operation. When a scanning is conducted from the first row to the n-th row sequentially, it is usually called forward scanning, and when a scanning is conducted from the n-th row to the first row sequentially, it is called backward scanning.

It needs to be emphasized that DC voltage signals provided by the embodiment of the present invention includes a first DC voltage signal and a second DC voltage signal. During the forward scanning, the first DC voltage signal is at a high level, and the second DC voltage signal is at a low level; and during the backward scanning, the first DC voltage signal is at a low level, and the second DC voltage signal is at a high level.

### Embodiment I

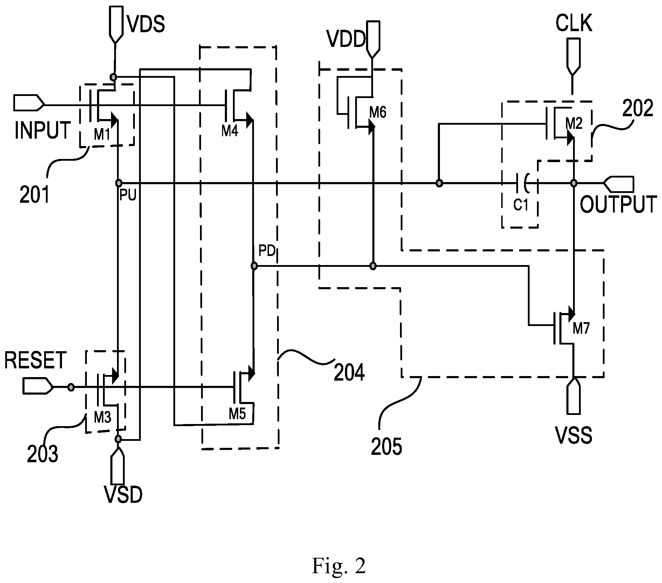

With reference to Fig. 2, the shift register provided by an embodiment of the present invention comprises a plurality of cascaded shift register elements, and the shift register element comprises an input module 201, an output module 202, a reset module 203, a first pull-down module 204 and a second pull-down module 205.

The input module 201 is configured to provide a first DC voltage signal VDS outputted by a first DC voltage signal terminal to a pull-up node PU as the output of the input module 201 in response to an input signal INPUT outputted by an input signal terminal.

The output module 202 is configured to provide a clock signal CLK outputted by a clock signal terminal to an output terminal OUTPUT of the shift register element in response to a voltage signal outputted by the pull-up node PU.

The reset module 203 is configured to provide a second DC voltage signal VSD outputted by a second DC voltage signal terminal to the pull-up node PU in response to a reset signal RESET outputted by a reset signal terminal.

The first pull-down module 204 is configured to provide the second DC voltage signal VSD outputted by the second DC voltage signal terminal to a pull-down node PD in response to the input signal INPUT outputted by the input signal terminal, or the first pull-down module is configured to provide the first DC voltage signal VDS outputted by the first DC voltage signal terminal to the pull-down node PD in response to the reset signal RESET outputted by the reset signal terminal, as the output of the first pull-down module 204.

The second pull-down module 205 is configured to provides a power supply anode voltage signal VDD outputted by a power supply anode to the pull-down node PD and to provide a power supply cathode voltage signal VSS outputted by a power supply cathode to the output terminal OUTPUT in response to the voltage signal of the pull-down node PD.

According to an embodiment of the present invention, the first DC voltage signal VDS and the second DC voltage signal VSD are respectively at different levels for the purpose of forward scanning and backward scanning. When the first DC voltage signal VDS is at a high level and the second DC voltage signal VSD is at a low level, forward scanning is conducted. When the first DC voltage signal VDS is at a low level and the second DC voltage signal VSD is at a high level, backward scanning is conducted.

According to the shift register provided by the embodiment of the present invention, when the first DC voltage signal VDS is at a high level and the second DC voltage signal VSD is at a low level, the first pull-down module 204 is configured to provide the high level of the first DC voltage signal VDS to the pull-down node PD in response to the high level of the reset signal RESET, and the second pull-down module 205 is configured to provide the power supply cathode voltage VSS to the output terminal OUTPUT in response to the high level of the pull-down node PD. When the first DC voltage signal VDS is at a low level and the second DC voltage signal VSD is at a high level, the first pull-down module 204 is configured to provide the high level of the second DC voltage signal VSD to the pull-down node PD in response to the high level of the input signal INPUT, and the second pull-down module 205 is configured to provide the power supply cathode voltage VSS to the output terminal OUTPUT in response to the high level of the pull-down node PD. Thus, the shift register element according to the embodiment of the present invention can pull down the output terminal by means of the DC voltage signals without relying on a high level of the clock signal to pull down the output terminal, which reduces the duty cycle of the clock signal and thereby lowers the power consumption of TFTs.

When the shift register is scanned forwards, the first DC voltage signal is at a high level and the second DC voltage signal is at a low level; and when the shift register is scanned backwards, the first DC voltage signal is at a low level and the second DC voltage signal is at a high level. Thus, when the shift register is scanned both forwards and backwards, the output terminal OUTPUT can be pulled down by means of DC voltage signals.

According to an embodiment of the present invention, the input module 201 comprises a first TFT M1. The control terminal of the first TFT M1 is connected to the input signal terminal INPUT, and the input terminal of M1 is connected to the first DC voltage signal terminal VDS, and the output terminal of M1 serves as the output node of the input module 201.

The output module 202 comprises a second TFT M2 and a first capacitor C1. The control terminal of the second TFT M2 is connected to the pull-up node PU, the input terminal of M2 is connected to the clock signal terminal CLK, and the output terminal of M2 is connected to the output terminal OUTPUT. The first capacitor C1 is connected between the pull-up node PU and the output terminal OUTPUT.

The reset module 203 comprises a third TFT M3. The control terminal of M3 is connected to the reset signal terminal RESET, the input terminal of M3 is connected to the second DC voltage signal terminal VSD, and the output terminal of M3 is connected to the pull-up node PU.

The first pull-down module 204 comprises a fourth TFT M4 and a fifth TFT M5. The control terminal of M4 is connected to the input signal terminal INPUT, the input terminal of M4 is connected to the second DC voltage signal terminal VSD, and the output terminal of M4 serves as the output node of the first pull-down module 204, i.e., as the pull-down node PD. The control terminal of the fifth TFT M5 is connected to the reset signal terminal RESET, the input terminal of M5 is connected to the first DC voltage signal terminal VDS, and the output terminal of M5 is connected to the pull-down node PD.

The second pull-down module 205 comprises a sixth TFT M6 and a seventh TFT M7. The control terminal and the input terminal of M6 are connected to the power supply anode voltage terminal VDD, and the output terminal of M6 is connected to the pull-down node PD. The control terminal of the seventh TFT M7 is connected to the pull-down node PD, the input terminal of M7 is connected to the power supply cathode voltage terminal VSS, and the output terminal of M7 is connected to the output terminal OUTPUT.

It needs to be explained that the control terminal in the embodiment of the present invention is the gate of the TFT, the input terminal is the source of the TFT and the output terminal is the drain of the TFT. Of course, when the TFT in the embodiment of the present invention is a P-type TFT, the input terminal is the drain of the TFT and the output terminal is the source of the TFT. All fall within the protection scope of the present invention as long as the connection manners remain unchanged.

Each shift register element in the shift register according to the above embodiments of the present invention only needs to be provided with seven TFTs and a capacitor. In comparison with the shift register element in the prior art, the above embodiment reduces the number of components provided for each shift register element, and decreases the area of the shift register element and therefore the entire area of the shift register, which is good for realizing the ultra-narrow frame design of the shift register.

When the shift register is scanned forwards, the first DC voltage signal VDS is at a high level and the second DC voltage signal VSD is at a low level. When the reset signal RESET is at a high level, the fifth TFT M5 of the first pull-down module 204 is switched on to introduce the high level of the first DC voltage signal VDS to the pull-down node PD, and the seventh TFT M7 of the second pull-down module 205 is switched on to introduce the low level of the power supply cathode voltage VSS to the output terminal OUTPUT.

When the shift register is scanned backwards, the first DC voltage signal VDS is at a low level, and the second DC voltage signal VSD is at a high level. When the input signal INPUT is a high level, the fourth TFT M4 of the first pull-down module 204 is switched on to introduce the high level of the second DC voltage signal VSD to the pull-down node PD, and the seventh TFT M7 of the second pull-down module 205 is switched on to introduce the low level of the power supply cathode voltage VSS to the output terminal OUTPUT. When the shift register is scanned both forwards and backwards, therefore, the output terminal can be pulled down by means of the DC voltage signals without being influenced by the high level of the clock signal, which reduces the duty cycle of the clock signal and lowers the power consumption of the TFTs.

A method for driving a shift register is provided by an embodiment of the present invention. The method comprises the steps of:
after receiving the input signal outputted by the input signal terminal, the input module providing the first DC voltage signal outputted by the first DC voltage signal terminal to the pull-up node as the output of the input module;
after receiving a voltage signal outputted by the pull-up node, the output module providing the clock signal outputted by the clock signal terminal to the output terminal of the shift register element;
after receiving the reset signal outputted by the reset signal terminal, the reset module providing the second DC voltage signal outputted by the second DC voltage signal terminal to the pull-up node;
the first pull-down module providing the second DC voltage signal outputted by the second DC voltage signal terminal to the pull-down node, after receiving the input signal outputted by the input signal terminal; and providing the first DC voltage signal outputted by the first DC voltage signal terminal to the pull-down node after receiving the reset signal outputted by the reset signal terminal, wherein the pull-down node is the output node of the first pull-down module;
after receiving a voltage signal of the pull-down node, the second pull-down module providing the power supply anode voltage signal outputted by the power supply voltage anode to the pull-down node and providing the power supply cathode voltage outputted by the negative power supply cathode to the output terminal.
wherein the second DC voltage signal is at a low level when the first DC voltage signal is at a high level, and is at a high level when the first DC voltage signal is at a low level.

It needs to be explained that when the shift register is scanned forwards, the first DC voltage signal is at a high level and the second DC voltage signal is at a low level; and when the shift register is scanned backwards, the first DC voltage signal is at a low level and the second DC voltage signal is at a high level.

When the shift register provided by the embodiment of the present invention is scanned both forwards and backwards, the output terminal can be pulled down by means of DC voltage signals, which reduces the duty cycle of the clock signal and lowers the power consumption of the TFTs.

### Embodiment II

The method for driving the shift register provided by the embodiment of the present invention will be described in detail.

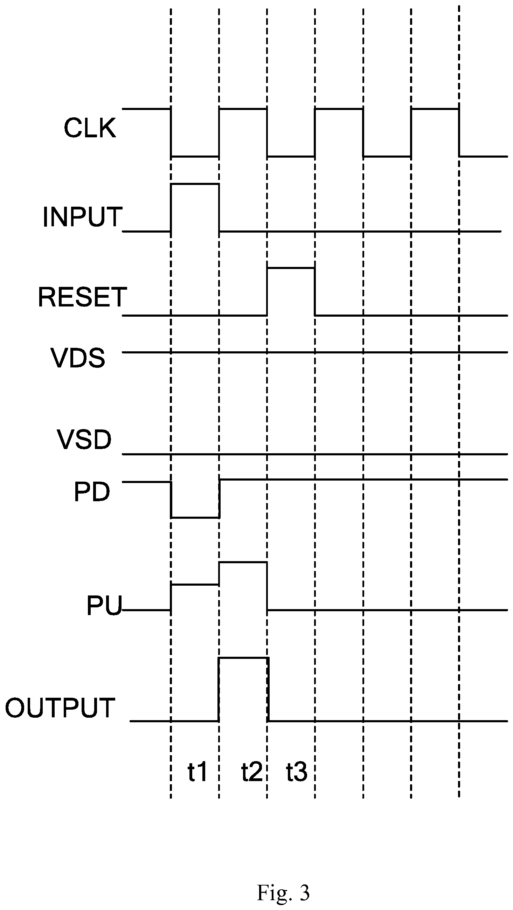

Fig. 3 shows a timing diagram for scanning the shift register forwards. When the shift register is scanned forwards, the first DC voltage signal VDS is at a high level and the second DC voltage signal VSD is at a low level.

With reference to the control signal timing diagram of Fig. 3, the method for driving the shift register provided by the embodiment I of the present invention comprises:
a first phase t1, wherein the input signal INPUT is at a high level, the clock signal CLK is at a low level, and the reset signal RESET is at a low level. At this time, the first TFT M1 is switched on to introduce the high level of the first DC voltage signal VDS to the pull-up node PU. When the pull-up node PU is at a high level, the first capacitor C1 is charged at both ends and meanwhile the second TFT M2 connected to the pull-up node PU is switched on to introduce the low level of the clock signal CLK to the output terminal OUTPUT. Since the input signal INPUT is at a high level, the fourth TFT M4 is switched on to introduce the low level of the second DC voltage signal VSD to the pull-down node PD, and meanwhile since the power supply anode voltage signal VDD is a high level, the sixth TFT M6 is switched on to introduce the high level to the pull-down node PD. Then, the high level and the low level are superposed at the pull-down node PD, so the pull-down node PD is not at a high level, and the seventh TFT M7 is switched off. Thus, in the first phase t1, the output terminal OUTPUT outputs a low level.
a second phase t2, wherein the input signal INPUT is at a low level, the clock signal CLK is at a high level, and the reset signal RESET is at a low level. At this time, the first TFT M1 is switched off, the pull-up node PU is pulled up again due to the bootstrapping function of the first capacitor C1, and the pull-up node PU is at a high level and thus the second TFT M2 continues to be switched on to introduce the high level of the clock signal CLK to the output terminal OUTPUT. The fourth TFT M4 is switched off, and the level of the pull-down node PD is affected only under the action of the sixth TFT M6. The six TFT M6 is switched on to introduce the high level of the power supply anode voltage VDD to the pull-down node PD which is at a high level. Since the drain of the seventh TFT M7 is connected to the output terminal, and the output terminal OUTPUT is at a high level in this phase, the high level of the pull-up node PD connected to the gate of the seventh TFT M7 is unable to switch on the seventh TFT. Thus, in the second phase t2, the low level of the power supply cathode voltage VSS will not be introduced to the output terminal OUTPUT and hence leakage of the output terminal is prevented. As a result, in the second phase t2, the output terminal OUTPUT outputs a high level.
a third phase t3, wherein the input signal INPUT is at a low level, the clock signal CLK is at a low level and the reset signal RESET is at a high level. At this time, the third TFT M3 is switched on to introduce the low level of the second DC voltage signal VSD to the pull-up node PU, the pull-up node PU is at a low level, and the second TFT M2 is switched off. The fifth TFT M5 is switched on to introduce the high level of the first DC voltage signal VDS to the pull-down node PD, and meanwhile the sixth TFT M6 is switched on to introduce the voltage of the power supply anode voltage VDD such that the pull-up node PD is at a high level and the switch-on of the seventh TFT M7 is accelerated. Since M7 is switched on to introduce the low level of the power supply cathode voltage VSS to the output terminal OUTPUT, the output terminal OUTPUT outputs a low level in the third phase t3.

After the third phase t3, due to the high level of the power supply anode voltage signal VDD, the sixth TFT M6 remains switched on to introduce the high level to the pull-down node PD. The high level of the pull-down node PD results in that the seventh TFT M7 is switched on to introduce the low level of the power supply cathode voltage VSS to the output terminal OUTPUT, so the output terminal OUTPUT remains at a low level until the next time the input signal INPUT is at a high level. In the next scanning cycle, the time sequence is again in the order of the first phase t1, the second phase t2 and the third phase t3, and corresponding operations in the first phase t1, the second phase t2 and the third phase t3 are performed again. That is, the fourth TFT M4 or the fifth TFT M5, together with the seventh TFT M7, discharges the output terminal OUTPUT, such that the output terminal OUTPUT of the shift register remains at a low level at all the time periods except the time period in which it outputs the high level. In the second phase t2, the seventh TFT M7 is switched off to prevent leakage when the output terminal OUTPUT outputs a high level. In the third phase t3, the high level of the first DC voltage signal VDS is introduced to the pull-down node PD, such that the seventh TFT M7 is switched on to introduce the low level of the power supply cathode voltage VSS to the output terminal OUTPUT, thereby enabling the output terminal OUTPUT to output a low level.

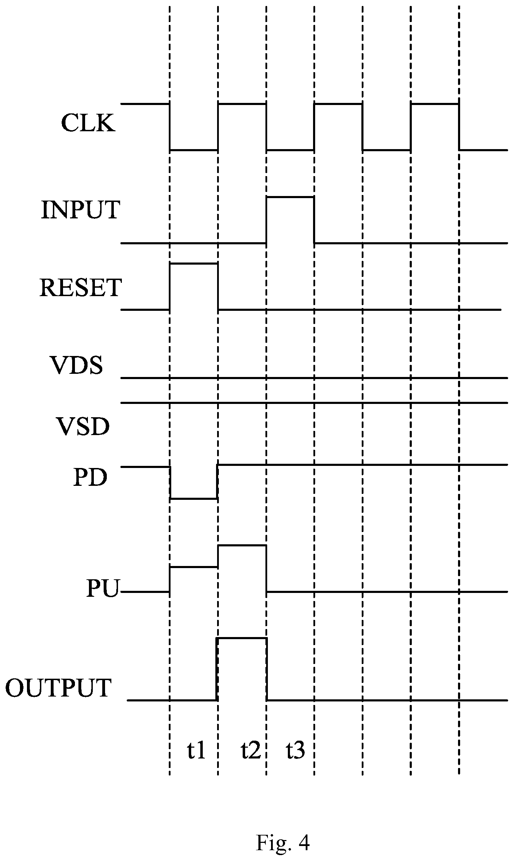

Fig. 4 shows a timing diagram for scanning the shift register backwards. When the shift register is scanned backwards, the first DC voltage signal VDS is at a low level and the second DC voltage signal VSD is at a high level.

With reference to the control signal timing diagram of Fig. 4, another method for driving the shift register provided by the embodiment I of the present invention comprises:
a first phase t1, wherein the input signal INPUT is at a low level, the clock signal CLK is at a low level, and the reset signal RESET is at a high level. The third TFT M3 is switched on to introduce the high level of the second DC voltage signal VSD to the pull-up node PU. When the pull-up node PU is at a high level, the first capacitor C1 is charged at both ends and meanwhile the second TFT M2 connected to the pull-up node PU is switched on to introduce the low level of the clock signal CLK to the output terminal OUTPUT. Since the reset signal RESET is at a high level, the fifth TFT M5 is switched on to introduce the low level of the first DC voltage signal VDS to the pull-down node PD, and meanwhile since the power supply anode voltage signal VDD is at a high level, the sixth TFT M6 is switched on to introduce the high level to the pull-down node PD. Then, the high level and the low level are superposed at the pull-down node PD, so the pull-down node PD is not at a high level, and the seventh TFT M7 is switched off. Thus, in the first phase t1, the output terminal OUTPUT outputs a low level.
a second phase t2, wherein the input signal INPUT is at a low level, the clock signal CLK is at a high level, and the reset signal RESET is at a low level. At this time, the third TFT M3 is switched off, the pull-up node PU is pulled up again due to the bootstrapping function of the first capacitor C1, and the pull-up node PU continues to be at a high level and the second TFT M2 continues to be switched on to introduce the high level of the clock signal CLK to the output terminal OUTPUT. The fifth TFT M5 is switched off, and the level of the pull-down node PD is affected only under the action of the sixth TFT M6. The six TFT M6 is switched on to introduce the high level of the power supply anode voltage VDD to the pull-down node PD which is at a high level. The gate of the seventh TFT M7 is connected to the high level of the pull-down node PD. Since the drain of the seventh TFT M7 is connected to the output terminal OUTPUT, the output terminal OUTPUT is at a high level, the seventh TFT M7 is switched off. Thus, in the second phase t2, the low level of the power supply cathode voltage VSS will not be introduced to the output terminal OUTPUT and leakage of the output terminal OUTPUT is prevented. As a result, in the second phase t2, the output terminal OUTPUT outputs a high level.
a third phase t3, wherein the input signal INPUT is at a high level, the clock signal CLK is at a low level and the reset signal RESET is at a low level. The first TFT M1 is switched on to introduce the low level of the first DC voltage signal VDS to the pull-up node PU, and the pull-up node PU is at a low level, and the second TFT M2 is switched off. The fourth TFT M4 is switched on to introduce the high level of the second DC voltage signal VSD to the pull-down node PD, and meanwhile the sixth TFT M6 is switched on to introduce the voltage of the power supply anode voltage VDD such that the pull-up node PD is at a high level and the switch-on of the seventh TFT M7 is accelerated to introduce the low level of the power supply cathode voltage VSS to the output terminal OUTPUT. Therefore, the output terminal OUTPUT outputs a low level in the third phase t3.

After the third phase t3, the output terminal OUTPUT remains at a low level until the next time the reset signal RESET is at a high level, which means the time sequence takes place again in the order of the first phase t1, the second phase t2 and the third phase t3, and corresponding operations in the first phase t1, the second phase t2 and the third phase t3 are performed again. That is, the fifth TFT M5 or the fourth TFT M4, together with the seventh TFT M7, discharges the output terminal OUTPUT, such that the output terminal OUTPUT of the shift register remains at a low level at all the time periods except the time period in which it outputs the high level. In the second phase t2, the seventh TFT M7 is switched off and it prevents leakage when the output terminal OUTPUT outputs a high level. Thus, in the third phase t3, the shift register provided by the embodiment of the present invention introduces the high level of the second DC voltage signal VSD to the pull-down node PD, such that the seventh TFT M7 is switched on to introduce the low level of the power supply cathode voltage VSS to the output terminal OUTPUT, thereby enabling the output terminal OUTPUT to output a low level.

To sum up, when the shift register is scanned forwards, the first DC voltage signal VDS is at a high level and the second DC voltage signal VSD is at a low level. When the reset signal is at a high level, the fifth TFT M5 is switched on to introduce the high level of the first DC voltage signal VDS to the pull-down node PD, and the seventh TFT M7 is switched on to introduce the low level of the power supply cathode voltage VSS to the output terminal OUTPUT. When the shift register is scanned backwards, the first DC voltage signal VDS is at a low level and the second DC voltage signal VSD is at a high level. When the input signal is at a high level, the fourth TFT M4 is switched on to introduce the high level of the second DC voltage signal VSD to the pull-down node PD, and the seventh TFT M7 is switched on to introduce the low level of the power supply cathode voltage VSS to the output terminal OUTPUT. Thus, when the shift register is scanned both forwards and backwards, the fourth TFT M4 and the fifth TFT M5 in the first pull-down module are switched on in turn to introduce the high level of the DC voltage signals to the pull-down node PD, such that the seventh TFT M7 is switched on to introduce the power supply cathode voltage VSS to the output terminal OUTPUT, thereby pulling down the output terminal OUTPUT by means of the DC voltage signals. Thus, the low level of the output terminal does not depend on the high level of the clock signal, which thereby reduces the duty cycle of the clock signal and lowers the power consumption of TFTs.

### Embodiment III

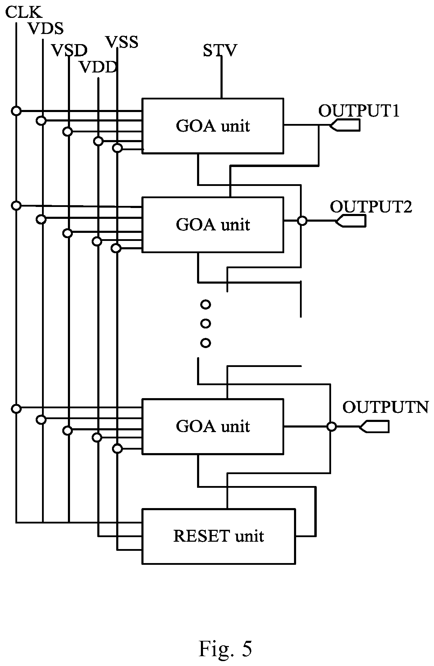

With reference to Fig. 5, the gate driving device provided by an embodiment of the present invention comprises any shift register provided by the embodiments of the present invention, including the cascaded shift register elements provided in the Embodiment I of the present invention. An entire gate driving circuit has altogether n-level GOA units, wherein n is the number of gate lines. The input signal INPUT of the first level is provided by a Start Vertical (STV) signal, the reset signal RESET of the first level is provided by the output signal OUTPUT of the second level, the input signal INPUT of the nth level is provided by the output signal OUTPUT of the nth-1 level, and the reset signal RESET of the nth level is provided by a reset unit RESET. For instance, the input signal INPUT of the nth level (1<n<N) is provided by the output terminal OUTPUT of the nth-1 level , and the reset signal RESET of the nth level is provided by the output terminal OUTPUT of the nth+1 level.

The display panel provided by an embodiment of the present invention comprises the gate driving device provided by the above embodiments of the present invention.

To sum up, the shift register provided by an embodiment of the present invention comprises a plurality of cascaded shift register elements, the shift register element comprises the input module in response to the input signal outputted by the input signal terminal, the output module in response to a voltage signal outputted by the pull-up node, the reset module in response to the reset signal outputted by the reset signal terminal, the first pull-down module in response to the input signal outputted by the input signal terminal and the reset signal outputted by the reset signal terminal, and the second pull-down module in response to a voltage signal of the pull-down node. The shift register can pull down the output terminal by means of the DC voltage signals, which reduces the duty cycle of the clock signal and thereby lowers the power consumption of the TFTs.

Apparently, a person of ordinary skill can make variations and modifications to the present invention within the spirit and scope of the present invention. If the variations and modifications of the present invention fall within the scope of the claims of the present invention and the equivalents thereof, the present invention is intended to embrace the variations and modifications.

## Claims

1. A shift register comprising a plurality of cascaded shift register elements, **characterized in that** each shift register element comprises:
an input module (201) configured to provide a first DC voltage signal (VDS) to a pull-up node as the output of the input module in response to an input signal (INPUT) of an input signal terminal;
an output module (202) configured to provide a clock signal (CLK) to an output terminal of the shift register element in response to a voltage signal outputted by the pull-up node;
a reset module (203) configured to provide a second DC voltage signal (VSD) to the pull-up node in response to a reset signal (RESET), wherein the second DC voltage signal is at a low level when the first DC voltage signal is at a high level, and is at a high level when the first DC voltage signal is at a low level;
a first pull-down module (204) configured to provide the second DC voltage signal (VSD) or the first DC voltage signal (VDS) respectively to the pull-down node as the output of the first pull-down module in response to the input signal (INPUT) of the input signal terminal or to the reset signal; and
a second pull-down module (205) configured to provide a power supply anode voltage signal (VDD) to the pull-down node and provide a power supply cathode voltage signal (VSS) outputted by a power supply cathode to the output terminal in response to a voltage signal of the pull-down node.

2. The shift register according to claim 1, **characterized in that** when the first DC voltage signal is at a high level and the second DC voltage signal is at a low level, the shift register is scanned forwards; and when the first DC voltage signal is at a low level and the second DC voltage signal is at a high level, the shift register is scanned backwards.

3. The shift register according to claim 1, **characterized in that** the input module comprises:
a first Thin Film Transistor, a control terminal of the first Thin Film Transistor being connected to the input signal terminal, an input terminal of the first Thin Film Transistor receiving the first DC voltage signal, and an output terminal of the first Thin Film Transistor being connected to the pull-up node.

4. The shift register according to claim 1, **characterized in that** the output module comprises:
a second Thin Film Transistor, a control terminal of the second Thin Film Transistor being connected to the pull-up node, an input terminal of the second Thin Film Transistor receiving the clock signal, and an output terminal of the second Thin Film Transistor being connected to the output terminal; and
a first capacitor connected between the pull-up node and the output terminal.

5. The shift register according to claim 1, **characterized in that** the reset module comprises:
a third Thin Film Transistor, a control terminal of the third Thin Film Transistor receiving the reset signal, an input terminal of the third Thin Film Transistor receiving the second DC voltage signal, and an output terminal of the third Thin Film Transistor being connected to the pull-up node.

6. The shift register according to claim 1, **characterized in that** the first pull-down module comprises:
a fourth Thin Film Transistor, a control terminal of the fourth Thin Film Transistor being connected to the input signal terminal, an input terminal of the fourth Thin Film Transistor receiving the second DC voltage signal, and an output terminal of the fourth Thin Film Transistor being connected to the pull-down node; and
a fifth Thin Film Transistor, a control terminal of the fifth Thin Film Transistor receiving the reset signal, an input terminal of the fifth Thin Film Transistor receiving the first DC voltage signal, and an output terminal of the fifth Thin Film Transistor being connected to the pull-down node.

7. The shift register according to claim 1, **characterized in that** the second pull-down module comprises:
a sixth Thin Film Transistor, a control terminal and an input terminal of the sixth Thin Film Transistor being connected to the power supply anode voltage, and an output terminal of the sixth Thin Film Transistor being connected to the pull-down node; and
a seventh Thin Film Transistor, a control terminal of the seventh Thin Film Transistor being connected to the pull-down node, an input terminal of the seventh Thin Film Transistor being connected to the power supply cathode voltage, and an output terminal of the seventh Thin Film Transistor being connected to the output terminal.

8. A gate driving device, **characterized by** comprising the shift register according to any of claims 1 to 7.

9. A display panel, **characterized by** comprising a gate driving device according to claim 8.

10. A method for driving the shift register according to any of claims 1 to 7, the method comprising the steps of:
the input module receiving the input signal of the input signal terminal and providing the first DC voltage signal to the pull-up node as the output of the input module;
the output module receiving the voltage signal outputted by the pull-up node and providing the clock signal to the output terminal of the shift register element;
the reset module receiving the reset signal and providing the second DC voltage signal to the pull-up node, wherein the second DC voltage signal is at a low level when the first DC voltage signal is at a high level, and is at a high level when the first DC voltage signal is at a low level;
the first pull-down module receiving the input signal and the reset signal, and providing the second DC voltage signal or the first DC voltage signal respectively to the pull-down node in response to the input signal or the reset signal; and
the second pull-down module receiving the voltage signal of the pull-down node, providing the power supply anode voltage signal to the pull-down node and providing the power supply cathode voltage to the output terminal.

11. The method for driving the shift register according to claim 10, **characterized in that** the shift register comprises a forward scanning mode and a backward scanning mode, wherein in the forward scanning mode, the first DC voltage signal is at a high level and the second DC voltage signal is at a low level, and in the backward scanning mode, the first DC voltage signal is at a low level and the second DC voltage signal is at a high level.
